# EUROPEAN PATENT APPLICATION

(11) **EP 4 726 401 A1**
(43) Date of publication of application: **15.04.2026**
(21) Application number: 25203631.4
(22) Date of filing: 22.09.2025
(51) Int. Cl.: G01R 31/26, G01R 31/28, G01R 31/317, G06F 11/07, G06F 13/40, G01R 31/3185, G01R 31/319, G01R 31/3193, G11C 29/00, G11C 29/44, G11C 29/04

(54) **SYSTEM FOR TESTING SEMICONDUCTORS AND CORRESPONDING TEST METHOD**

(30) Priority: 11.10.2024 IT 202400022632
(71) Applicant: STMicroelectronics International N.V., 1228 Plan-les-Ouates, Geneva (CH)
(72) Inventor: POLLACCIA, Giorgio, I-90123 Palermo (IT); ZOPPI, Giulio, I-90121 Palermo (IT); CAMARDA, Francesco, I-90014 Casteldaccia (Palermo) (IT); RUMI, Giuseppe, I-20845 Sovico (Monza Brianza) (IT)
(74) Representative: Buzzi, Notaro & Antonielli d'Oulx S.p.A.

(57) **Abstract**

A system for testing semiconductor devices (W), comprises a probing array of individual cells (CELL[0,0], CELL[0,M]; CELL[1,0], CELL[1,M]; ...; CELL[N,0], CELL[N,M]) configured to co-operate with respective semiconductor devices under test (DUT[0,0], DUT[0,M]; DUT[1,0], DUT[1,M]; ...; DUT[N,0], DUT[N,M]). The individual cells in the probing array (PS) are configured (10[0,0], 10[0,M]; 10[1,0], 10[1,M]; ...; 10[N,0], 10[N,M]) to apply electrical stimulation signals to the respective semiconductor device under test and to detect a fault condition in the respective semiconductor device under test based on electrical reaction signals received therefrom in response to said electrical stimulation signals applied thereto. The individual cells in the probing array are configured to be at least temporarily disabled in response to a fault condition detected in the respective semiconductor device under test with cell clusters (CLUSTER[0], CLUSTER[1], ..., CLUSTER[N]) configured to issue alert signals (ALERT[0], ALERT[1], ..., ALERT [N]) indicative of a fault condition detected in at least one individual cell therein. Based on these alert signals, which can be managed either individually or as combined alert signals common to plural cell clusters, logic circuitry (30) performs a query of individual cells in the probing array and identifies individual cells in the probing array (PS) wherein a fault condition is detected in the respective semiconductor device under test. The system can permanently disable individual cells (CELL[0,0], CELL[0,M]; CELL[1,0], CELL[1,M]; ...; CELL[N,0], CELL[N,M]) wherein a persisting fault condition is detected.

## Description

### Technical field

The description relates to testing semiconductors.

One or more embodiments can be applied, for instance, to complex testers configured to operate on large numbers of devices under test (DUTs).

### Description of the related art

In complex testers managing a large number of devices under test (by the tens and more, for instance) it is desirable that DUT-related supply, enable, alert and fault conditions should be managed as independently as possible for each DUT.

To that effect, a number of semiconductor dice can be tested in parallel and testing can be managed via a two-level logic consisting of a supervisory logic including a dedicated logic that can be implemented with a Field Programmable Gate Array (FPGA).

Systems for testing semiconductors are costly equipment and adequate protection against damage is of primary importance: hence, fault conditions (a shorted DUT, just to make an example) should desirably be detected as rapidly as possible and the related positions in a wafer under test likewise disqualified as rapidly as possible.

The inherent complexity of such a system deserves to be managed with adequate architectural choices based on a modular approach, taking into account constraints associated with factors such as size, available resources and easy maintainability.

For instance, in wafer-level testers including probing arrays with a high degree of parallelism (200 DUTs in parallel, for instance) a whole wafer should desirably be tested with a limited number of "touchdowns".

Protection of the equipment is a priority in so far as probes are costly and should be protected against short circuit events ("shorts").

Also:
testing throughput should desirably remain essentially unaffected in case of a faulty event impacting a DUT, with the electronics serving the faulty DUT disabled while the test is still running for the other devices;
electronics associated to each DUT should facilitate providing alerts to a tester with the possibility of singling out the source of an alert and taking appropriate actions in response;
a telemetry feature is desirable in order to facilitate monitoring relevant parameters such as voltages and currents that are forwarded to a tester;
configurable power-on/power-off sequences and/or configurable alerts available for sensitive rails represent a valuable asset.

Documents such as US 2020/174073 A1 and, to a lesser extent, US 2024/006008 A1, US 10 930 327 B1, US 2024/310439 A1 or US 2016/334461 A1 are exemplary of the prior art.

### Object and summary

An object of one or more embodiments is to contribute in addressing the issues outlined in the foregoing.

According to one or more embodiments, such an object can be achieved via a system for testing semiconductors having the features set forth in the claims that follow.

One or more embodiments may relate to a corresponding method.

The claims are an integral part of the technical teaching provided herein in respect of the embodiments.

Solutions as described herein include cells that can be programmed in terms of rail power-on sequence within a cell, alert values and other factors with testing continuing in the other cells - other than the "disqualified" ones - while telemetry is collected run-time, formatted and forwarded to a tester.

Essentially, a "cell" as discussed herein identifies all the electronics serving/common to a single DUT, with several cells instantiated within a "cluster".

In solutions as described herein, faults can be managed (at a cell level) with a supply rail detecting a fault (an overcurrent, for instance) setting an alert which is common to a whole cluster (of cells).

This optimizes using the logic resources, with a safeguard mechanism (shutdown or foldback, for instance) implemented immediately for the cell related to the fault (the "faulty" cell) which facilitates protecting the equipment (the costly probes, for instance).

In solutions as described herein, a cell may store information (a flag) indicating the element impacted by a fault condition; logic circuitry may thus query the cluster in order to retrieve the related information, and thus identify a faulty cell, in response to an alert flag processed by the control logic.

In solutions as described herein, fault management (via a control logic) benefits from the cells being self-protected, so that alerts can be processed with (relatively) low priority, with no substantial impact on the ongoing test.

In solutions as described herein, once an alert is triggered, logic circuitry can identify the cluster to whom the alert applies and perform a query of the elements within the cluster (with the test running for the remaining DUTs) to single out the cell related to the fault and the faulty supply rail.

That information can be relayed to a tester to decide adequate action; for instance, while a cell is disabled - temporarily -- if the issue is related to a DUT associated therewith, a cell can be marked as damaged/disqualified -- permanently, that is until serviced and fixed -- if the fault is related to the cell electronics, which can be detected if the cell persists in being found faulty once associated to another DUT in a subsequent touch-down.

### Brief description of the annexed figures

One or more embodiments will now be described, by way of example only, with reference to the annexed figures, wherein:
Figure 1 is a functional block diagram of a system for testing semiconductors;
Figure 2 is a more pictorial representation of a system for testing semiconductors;
Figure 3 is a block diagram illustrative of architecture of a test system as described herein; and
Figures 4 to 8 are exemplary circuit diagrams illustrative of possible ways of implementing certain blocks in a system as described herein.

The figures are drawn to clearly illustrate the relevant aspects of the embodiments and are not necessarily drawn to scale.

The edges of features drawn in the figures do not necessarily indicate the termination of the extent of the feature.

### Detailed description of exemplary embodiments

In the ensuing description, one or more specific details are illustrated, aimed at providing in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

Unless the context indicates otherwise, like parts or elements are indicated throughout the figures annexed herein with like references/numerals and for the sake of brevity a corresponding description will not be repeated for each figure.

For the sake of simplicity and ease of explanation, a same designation may be applied throughout this description to designate:
a certain node or line as well as a signal occurring at that node or line;
a certain component (such as a capacitor, resistor or inductor of coil) as well as electrical parameters thereof.

Also, when it is mentioned that an element is "connected to" or "coupled to" another element, it should be understood that still another element may be interposed therebetween, as well as that the element may be connected or coupled directly to another element.

On the contrary, when it is possibly mentioned that an element is "connected directly to" or "coupled directly to" another element, it should be understood that still another element is not interposed therebetween.

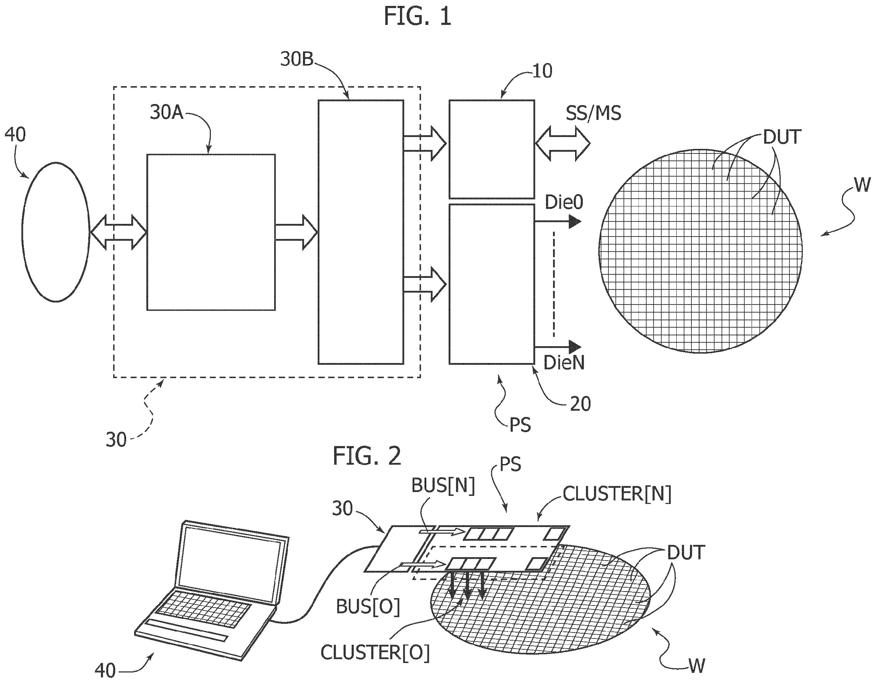

Figure 1 is a functional block diagram of a wafer-level system for testing semiconductors such as, for instance, semiconductor dice included in a semiconductor wafer W.

These semiconductor dice are exemplary of what is referred throughout this description as a device under test, DUT.

A wafer W may include a (very) high number of DUTs and testing involves repeated "touchdown" impacts by a probing array PS, with each touchdown involving a certain number of DUTs (about 200, for instance) while the total number of DUTs in the wafer is generally higher, so that plural touchdowns are involved in processing a whole wafer W.

The DUTs are tested by applying thereto test signals ("stimuli", SS in Figure 1) and collecting monitoring signals (MS in Figure 1) that convey the reaction of the DUTs to the stimuli.

As represented in Figure 1, stimuli SS and monitoring signals are applied to the DUTs/collected from the DUTs via pin (fault detection) electronics 10 including probes (pins) in a probing array PS that (as schematically represented in Figure 2) can "touchdown" onto the wafer W and establish electrical contact with the DUTs at selected locations.

As represented in Figure 1, a power management IC (PMIC) array 20 is provided to selectively apply electrical power to the DUTs (Die0, ..., DieN).

As further discussed in the following, the probing array PS includes individual cells that are arranged in clusters.

Operation of the fault detection electronics 10 and the PMIC array 20 can be supervised by a supervisory control logic 30 including control logic circuitry 30A and a cluster logic 30B with the test results reported to a tester 40.

The cluster logic replicates for each cluster the action set by 30A and is in charge for the response to local alerts.

As visible in the more pictorial representation of Figure 2, the tester 40 may be implemented using a personal computer, PC.

The tester 40 communicates with the control logic 30 that in turn communicates with the probing array PS. The probing array PS can be regarded as including individual cells arranged in clusters CLUSTER[0], ..., CLUSTER[N], with the control logic 30 communicating with the cell clusters CLUSTER[0], ..., CLUSTER[N] via control buses BUS[0], ..., BUS[N].

Essentially, a cell as discussed herein identifies all the electronics serving/common to a single DUT, with several cells instantiated within a cluster.

It will be appreciated that embodiments as described herein are primarily concerned with the way testing is managed (how alerts are managed, for instance) rather than with the way testing of the DUTs is performed, namely the mechanism underlying generation of the alerts (an overcurrent detected, for instance): for the purposes herein, testing can be performed in any way known to those of skill in the art in view of the type and nature of the devices under test.

It is otherwise noted that testing devices for failures (faults) represent a highly developed area of investigation, as witnessed, merely by way of example, by documents such as US 10 916 326 B1 or US 2021/382536 A1.

Document US 10 916 326 B1 discloses handling information on DIMM failures (events that lead to the logical state of one or multiple bits being read differently from how they were last written) using a processor and memory devices that each include a voltage regulator configured to be enabled by a command from the processor. The processor boots the information handling system, including providing the command to the memory devices, and detects that one of the memory devices failed to boot. The processor determines that it is unknown whether the failing memory device is the first memory device or the second memory device. In response, the processor determines which one of the memory devices failed to boot, by rebooting the information handling system, providing a command to a selected one of the memory devices, and determining whether or not the selected one of the memory devices failed to boot.

Document US 2021/382536 A1 discloses handling fault events in a controller chip that includes a first cluster including one or more first controller units, a first power supply grid, a first clock tree structure to supply one or more clock signals, and at least a first power supply input. A second cluster includes one or more second controller units, a second power supply grid, a second clock tree structure to supply one or more clock signals, and at least a second power supply input. A monitoring cluster includes a monitoring circuit configured to monitor the power supply and the clock signal supply of each of the first cluster and second cluster, and in the event of determining at least one of a power supply failure or a clock signal supply failure in one cluster of the first cluster or the second cluster, indicate the failure to the other cluster to take one or more actions.

Other background documents include US 2023/168259 A1, US 2022/253358 A1, US 2023/267047 A1, US 2022/224101 A1, US 2022/101043 A1, and US 2019/041938 A1.

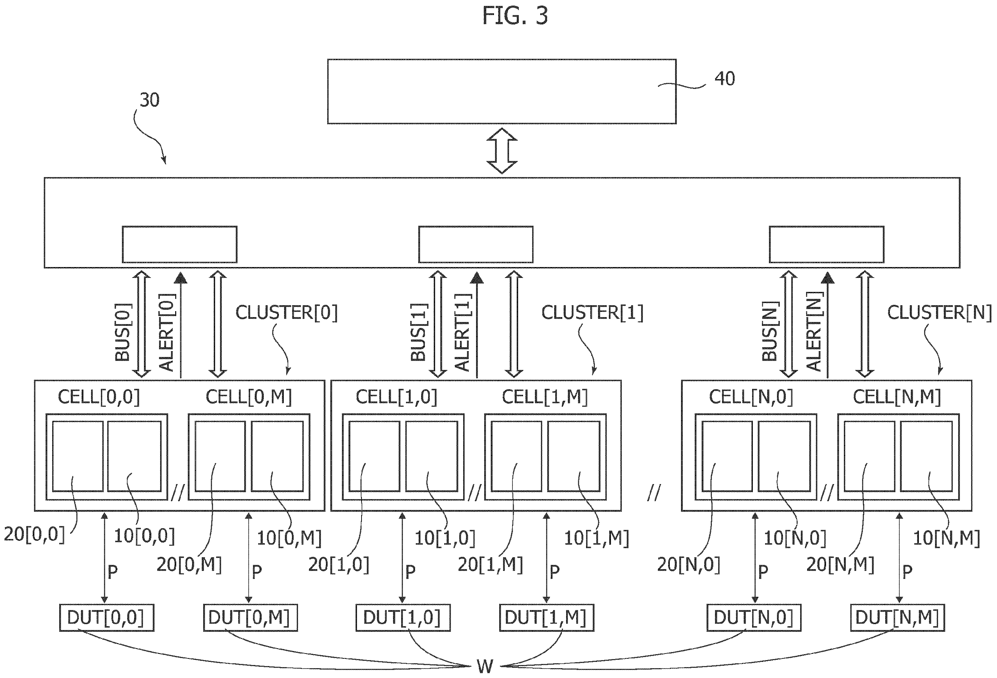

Figure 3 is a block diagram illustrative of architecture of a system as described herein wherein parts or elements like parts or elements already introduced in connection with Figures 1 and 2 are indicated with like reference symbols, and a corresponding detailed description will not be repeated for brevity.

It is otherwise noted that, while represented in Figure 3 for completeness, the tester 40 (a personal computer as illustrated in Figure 2, for instance) may represent a distinct element from the embodiments.

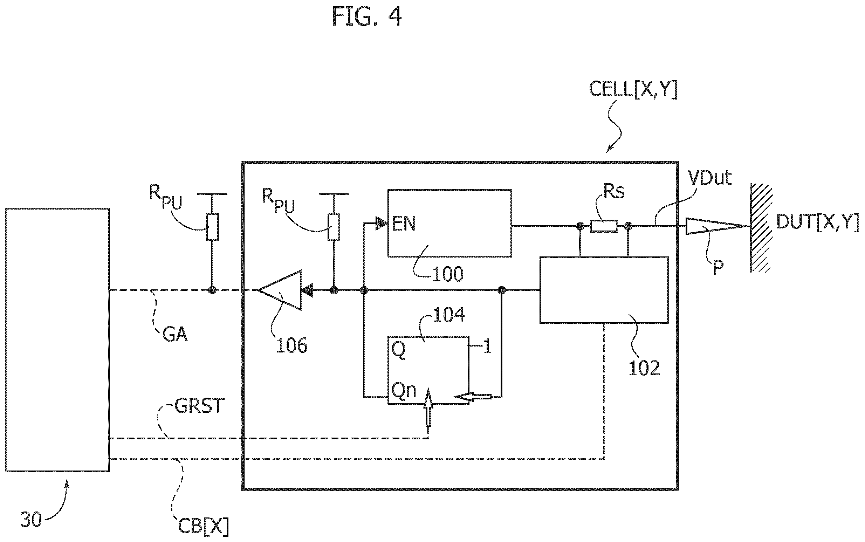

The tester 40 may be coupled to the logic circuitry 30 of the system described herein (only) by an end user to coordinate testing and collect the tests results via a probing array PS including fault detection electronics 10, oftentimes referred to as "pin electronics" in so far as it includes probes (pins - indicated by the symbol P in Figures 4 to 8) configured to "touchdown" onto a corresponding set of DUTs labelled DUT[0,0], DUT[0,M]; DUT[1,0], DUT[1,M]; ...; DUT[N,0], DUT[N,M] included in wafer W undergoing testing.

As illustrated in Figure 3, the probing array PS can be regarded as including individual cells CELL[0,0], CELL[0,M] ; CELL[1,0], CELL[1,M]; ...; CELL[N,0], CELL[N,M] each adapted to co-operate (once the probing array PS "touches-down" onto the wafer W) with a respective DUT in the wafer W DUT[0,0], DUT[0,M]; DUT[1,0], DUT[1,M]; ...; DUT[N,0], DUT[N,M] so that probes P in the cell establish electrical contact with selected locations of the associated DUT.

It is noted that the DUTs are not a part of the testing system.

Consistently with the representation in Figure 1, each cell CELL[0,0], CELL [0,M] ; CELL[1,0], CELL[1,M]; ...; CELL[N,0], CELL[N,M] includes:
fault detection electronics ("pin" electronics) 10[0,0], 10[0,M]; 10[1,0], 10[1,M]; ...; 10[N,0], 10[N,M] to apply to the associated DUT/collect from the associated DUT stimuli SS and monitoring signals MS; and
power management integrated circuits, ICs (PMICs) 20[0,0], 20[0,M]; 20[1,0], 20[1,M]; ...; 20 [N, 0], 20[N,M] to selectively apply electrical power to the DUTs, possibly on a cluster basis.

A DUT generally requires plural supply rails; hence, several PMICs (and linear regulators) are usually included in each cell. Advantageously, PMICs and linear regulators are (purely) analog; in the case of rails with limited current capability, a linear regulator can be an advantageous choice because of its simplicity, lower cost and smaller size in comparison to a (switching) PMIC.

As illustrated in Figure 3, the individual cells in the probing array PS can be arranged in clusters.

More specifically, as represented in Figure 3:
a first cluster CLUSTER[0] includes cells from CELL[0,0] to CELL[0, M];
a second cluster CLUSTER[1] includes cells from CELL[1,0] to CELL[1, M];
and so on up to
a cluster CLUSTER[N] that includes cells from CELL[N,0] to CELL[N, M].

It is noted that all the clusters being described as including a same number of cells is merely for simplicity and is not imperative. The way cells are arranged in clusters, the number of cells within the clusters and the number of clusters may be determined based on a judicious trade-off between performance, complexity, and other related factors, while the electronics within each cell is related to characteristics of the DUTs being tested.

The logic 30 communicates with the cell clusters CLUSTER[0] to CLUSTER[N] via the respective buses BUS[0] to BUS[N] with the clusters CLUSTER[0] to CLUSTER[N] that are configured to send to the logic 30 respective alert signals ALERT[0] to ALERT [N].

As discussed in the following, managing alerts individually (that is, an alert per cluster) may be advantageous but is not mandatory.

As illustrated in Figure 3, architecture as proposed herein includes a series of (e.g. multiple PMIC-based) clusters CLUSTER[0] to CLUSTER[N] of cells controlled by a control bus. The control bus can be split for the various clusters as illustrated by BUS[0] to BUS[N] in Figure 3 or, alternatively, can include one or more combined buses (a "global" bus, for instance), according to the available resources and the design scalability strategy.

Whatever specific option is adopted in that respect, the individual cells CELL[0,0], CELL[0,M]; CELL[1,0], CELL[1,M]; ...; CELL[N,0], CELL[N,M] in the probing array PS can be configured - via the elements 104 or 202 as discussed in the following, for instance - to be (at least temporarily) disabled in response to a fault condition detected in the respective semiconductor device under test DUT[0,0], DUT[0,M]; DUT[1,0], DUT[1,M]; ...; DUT[N,0], DUT[N,M].

This facilitates achieving immediate protection of the cells (and the test equipment as a whole).

The related information can be stored in the cell involved and the cell clusters CLUSTER[0], CLUSTER[1], ..., CLUSTER [N] can be configured to issue respective alert signals ALERT[0], ALERT[1], ..., ALERT [N] indicative of a fault condition detected in at least one individual cell therein.

The logic 30, triggered by these alerts can thus query the status of the cells which are related to the alert(s) involved looking for the faulty site, in case of HW damage.

Referring herein to individual (local) alerts is primarily for ease of explanation.

In fact (for instance, in the case of limited resources available in terms of logic/FGPA) the "local" alerts issued by plural clusters can be combined (OR-ed, for instance) and forwarded (per groups of clusters or globally, as a global or general alert) to the logic 30. In that case, reaction will involve a query extended towards the cells in all the clusters underlying a combined alert.

Figure 3 illustrates architecture of a system for testing semiconductor devices (in a wafer W, for instance) comprising a probing array PS of individual cells CELL[0,0], CELL [0,M] ; CELL[1,0], CELL[1,M]; ...; CELL[N,0], CELL[N,M] that are configured to co-operate with respective semiconductor devices under test DUT[0,0], DUT[0,M]; DUT[1,0], DUT[1,M]; ...; DUT[N,0], DUT [N,M] .

As exemplified in Figure 3, the individual cells CELL[0,0], CELL [0,M] ; CELL[1,0], CELL[1,M]; ...; CELL[N,0], CELL[N,M]) in the probing array PS include cell power supply circuitry 20[0,0], 20[0,M]; 20[1,0], 20[1,M]; ...; 20[N,0], 20[N,M] to selectively apply electrical power to respective semiconductor devices under test DUT[0,0], DUT[0,M]; DUT[1,0], DUT[1,M]; ...; DUT[N,0], DUT[N,M] as well as fault detection electronics 10[0,0], 10[0,M]; 10[1,0], 10[1,M]; ...; 10[N,0], 10[N,M] configured to apply electrical stimulation signals SS to the respective semiconductor devices under test DUT[0,0], DUT[0,M]; DUT[1,0], DUT[1,M]; ...; DUT[N,0], DUT[N,M] and to detect a fault condition in the respective semiconductor device under test based on electrical reaction signals MS received therefrom in response to electrical stimulation signals SS applied thereto.

As exemplified in Figure 3, the individual cells CELL[0,0], CELL [0,M] ; CELL[1,0], CELL[1,M]; ...; CELL[N,0], CELL[N,M] in the probing array PS are arranged in cell clusters CLUSTER[0], CLUSTER[1], ..., CLUSTER[N] that are configured to issue respective alert signals ALERT[0], ALERT[1], ..., ALERT [N] in response to a fault condition detected in an individual cell CELL[0,0], CELL [0,M] ; CELL[1,0], CELL[1,M]; ...; CELL[N,0], CELL [N,M] ; that cell can be immediately disabled in order to facilitate cell/system (self)protection.

As further discussed in the following, the alert signals (and action taken in response thereto) can be managed on a cluster basis or as combined alert signals (in certain embodiments, a single global alert signal) resulting from combining (OR-ing, for instance) alert signals from plural clusters.

To summarize:
a system for testing semiconductor devices (in a wafer W, for instance) as discussed herein comprises a probing array PS of individual cells CELL[0,0], CELL [0,M] ; CELL[1,0], CELL[1,M]; ...; CELL[N,0], CELL[N,M] configured to co-operate with respective semiconductor devices under test DUT[0,0], DUT[0,M]; DUT[1,0], DUT[1,M]; ...; DUT[N,0], DUT[N,M];
the individual cells CELL[0,0], CELL[0,M]; CELL[1,0], CELL[1,M]; ...; CELL[N,0], CELL[N,M] in the probing array PS are configured to be at least temporarily disabled in response to a fault condition being detected in the respective semiconductor device under test DUT[0,0], DUT[0,M]; DUT[1,0], DUT[1,M]; ...; DUT[N,0], DUT[N,M]; and
the individual cells in the probing array are arranged in cell clusters CLUSTER[0], CLUSTER[1], ..., CLUSTER[N], configured to issue alert signals ALERT[0], ALERT[1], ..., ALERT [N] indicative of a fault condition detected in at least one individual cell therein.

Combination circuitry can be possibly provided and configured to combine respective alert signals ALERT[0], ALERT[1], ..., ALERT [N] from a plurality of cell clusters to produce therefrom at least one combined alert signal common to a plurality of cell clusters CLUSTER[0], CLUSTER[1], ..., CLUSTER[N].

A concept underlying such an approach is that the cells immediately protect themselves and issue an alert, with such self-protection action taking place immediately and not in response to an alert. Alerts can thus be processed with (relatively) low priority, with no substantial impact on an on-going test.

This may apply both to those forms of implementation where alerts are managed on a cluster basis and to those forms of implementation where alerts are managed as combined alerts (as a global alert signal, for instance) .

Figures 4 to 8 are exemplary circuit diagrams illustrative of possible ways of implementing the cells CELL[0,0], CELL [0,M] ; CELL[1,0], CELL[1,M]; ...; CELL[N,0], CELL[N,M], that is C[X, Y] (X = 0, ..., N and Y = 0, ..., M.

In the following, the logic 30 can be assumed to rely on limited logical resources (for cost and space reasons) .

As illustrated in Figure 4, a possible way of implementing a cell C[X, Y] includes a regulator 100 with an enable input EN plus a voltage/current (V/I) meter 102 controlled by the logic circuitry 30 via a control bus (this can be referred to as CB[X}).

The voltage/current (V/I) meter 102 is configured to detect a fault condition in an associated DUT[X,Y] to which electrical contact is established via probes (pins) P touching-down (in manner known per se) on the DUT.

By way of example, this may occur as a function of a voltage drop sensed across an amperometry resistor Rs arranged in a VDut line and thus capable of sensing a reaction signal from the DUT to which the cell CELL [X, Y] is associated, that is electrically coupled in response to the probes P in the probing array PS "touching-down" onto the wafer W) to establish electrical contact with selected locations of a respective associated DUT so that:
electrical stimulation signals (see SS in Figure 1) are applied to the respective semiconductor device under test, and
a fault condition in the respective semiconductor device under test is detected based on electrical reaction signals (see MS in Figure 1) received from that device under test in response to electrical stimulation signals SS applied thereto.

A cell C[X,Y] can be configured so that, in response to a fault condition being detected in an associated DUT[X,Y] to which electrical contact is established via probes (pins) P touching-down:
the cell is (at least temporarily) disabled, thus providing immediate self-protection of the cell; and
a corresponding alert signal is generated to be sent towards the logic 30.

In that respect it is once more recalled that embodiments as described herein are not primarily concerned with the mechanism underlying fault detection, namely the way testing of the DUTs is actually performed (for instance, it is noted that fully digital PMICs can "natively" generate alerts and store the related information): for the purposes herein, such testing can be performed in any way known to those of skill in the art in view of the type and nature of the devices under test.

By way of simple (and non-limiting) example:
an output from the V/I meter 102 which indicates a fault detected via the V/I meter 102 in the associated device under test DUT[X, Y] can be applied to a flip-flop 104 and the related information can be stored in the flip-flop 104 as a flag indicative of a faulty condition detected;
the flip-flop 104 can act on an enable input EN of the regulator 100 (which acts as power supply circuit to the cell and, possibly, the respective semiconductor device under test) so that the regulator 100 is shut down thus discontinuing power supply to the cell C[X,Y], which is (at least temporarily) disabled, and
a "cell faulty" signal can be forwarded towards the logic 30.

At system level, this latter action may take place on a cluster basis, that is with an alert signal ALERT[0], ..., ALERT[N] issued from a cell cluster wherein a fault condition has been detected in one cell in the cluster, thus at least temporarily "disqualifying" the associated testing site, while the faulty cell is in any case (self)protected by being disabled.

As discussed, testing throughput should desirably remain unaffected in case of a faulty event impacting a DUT, with (only) the electronics serving the faulty DUT disabled while the test is kept running for the other devices.

As illustrated in Figure 4, the signal on the output line from the V/I meter 102 can be forwarded to an output digital buffer (OD buffer) 106 (advantageously, this is interposed between two pull-up resistors R_{PU}) to be supplied to the logic 30.

Once such an alert has been processed by the logic 30, the buffer 106 can be set to a high-impedance (high-Z) state so that a "combined" alert can be possibly released. While this is not visible for simplicity, the buffer 106 can be provided with an enable input that is controlled by the control logic 30 (possibly via additional logic within the cell).

That is, the signal from the V/I meter 102, the enable signal EN of the regulator 100 and the output of the latching element (flip-flop 104) can be linked together (at the OD-line, acting as wired or gate).

The buffer 106 is also exemplary of combination circuitry configured to co-operate with the logic circuitry 30 to combine (as a wired-OR combination, for instance) respective alert signals from a plurality of cell clusters CLUSTER[0], CLUSTER[1], ..., CLUSTER[N] to produce therefrom one or more combined alert signals, with each combined alert signal common to a plurality (a set) of cell clusters. For simplicity, by way of non-limiting example, one may consider combination circuitry configured to combine the respective alert signals from all of the cell clusters to produce therefrom a single "global" alert signal GA common to all of the cell clusters.

In response to receiving an alert signal (for simplicity of explanation one may consider at first the case of a distinct alert signal ALERT[0], ALERT[1], ..., ALERT [N] received for one of the cell clusters) the logic circuitry 30 can perform, for instance via the line indicated as GRST in Figure 4, a query of the individual cells in that cluster and identify the individual cell that has stored therein (in the flip-flop 104, for instance) a flag indicative of a fault condition detected in the cell.

In the case of a distinct alert signal ALERT[0], ALERT[1], ..., ALERT [N] received for (from) each one of the cell clusters the logic circuitry 30 can limit that query to the individual cells included in the cell cluster that has issued a respective alert signal ALERT[0], ALERT[1], ..., ALERT [N].

In the presence of combination circuitry configured to combine alert signals ALERT[0], ALERT[1], ..., ALERT [N] from plural cell clusters (a single global alert signal GA common to all of the cell clusters can be considered for simplicity) the logic circuitry 30 will extend the query to the individual cells included in those cell clusters that have contributed via respective alert signals to a combined alert signal to which the logic circuitry reacts.

The result of the query (however performed) is reported by the logic to the tester 40 that can thus identify DUTs found to be "defective" and take appropriate action: for instance, the DUTs in question can be marked as defective and candidate to be discarded (in a manner known per se to those of skill in the art, for instance after wafer "singulation").

As discussed, the individual cells in the probing array PS are configured to be at least temporarily disabled (via the flip-flop, for instance 104) in response to a fault condition detected in the respective semiconductor device under test (DUT) to provide self-protection of the cells.

This "faulty" condition can be related to a fault in the respective semiconductor device under test (DUT), which can be marked as defective and discarded.

Thus, the faulty condition is not related to a (HW, for instance) fault in the cell, that once temporarily disabled for protection can be re-enabled for testing another DUT during a subsequent touch-down action.

To that effect, the logic circuitry 30 may issue (over the line GRST, for instance) a (global) reset signal GRST to be relayed to the input EN of the regulator 100 via the flip-flop 104 to re-enable the cell for a next touchdown.

Clusters (and alert signals: on an individual cluster basis or combined) can be defined based on a judicious trade-off between available resources and performance.

Factors coming into play in that respect may include, for instance, a limited pool of available physical addresses, which militates against having a single control bus; the same also applies to the query in response to an alert: querying each device is less efficient than querying only the pool of devices within a cluster.

Another limiting factor is the complexity related to managing too many devices with a single bus. For instance, Inter-Integrated Circuit I2C (a simple two-wire serial protocol used to communicate between two devices or chips in an embedded system) can in principle manage up to 127 different addresses (if available), but devising a single bus layout for 127 devices would be overly complex. The basic cells exemplified herein can in fact be combined with additional logic to implement more complex features.

In certain circumstances, a "faulty" condition detected for a cell may be related to a fault in the cell (shorted pins, for instance) and thus persist. For instance, once re-enabled for testing another DUT during a subsequent touch-down action, a certain cell can be again found to be faulty. A repeated occurrence of such an event can be detected by the tester as indicative of a persisting fault in the cell, that requires to be fixed (serviced, for instance).

A system as discussed herein can thus be configured to disable individual cells in the probing array PS found to have persistently stored therein (in the flip-flop 104, for instance) a flag indicative of a fault condition detected in the cell during subsequent touchdown actions. These cells can thus be disabled permanently, that is until fixed (serviced).

In order to facilitate operation as discussed previously, after querying ("polling") the memory element in a cell as represented, for example, by the flip-flop 104, the logic 30 can act on the regulator 100 and keep the individual "faulty" cell in a shut-down state even if the V/I meter 102 therein is reset.

It is noted that referring to a single cell and thus to a single cluster found to be faulty (for instance, found to be associated to a DUT where a fault condition is detected) is essentially for simplicity and ease of explanation: in fact, plural cells and thus plural clusters can be found to be faulty in practice.

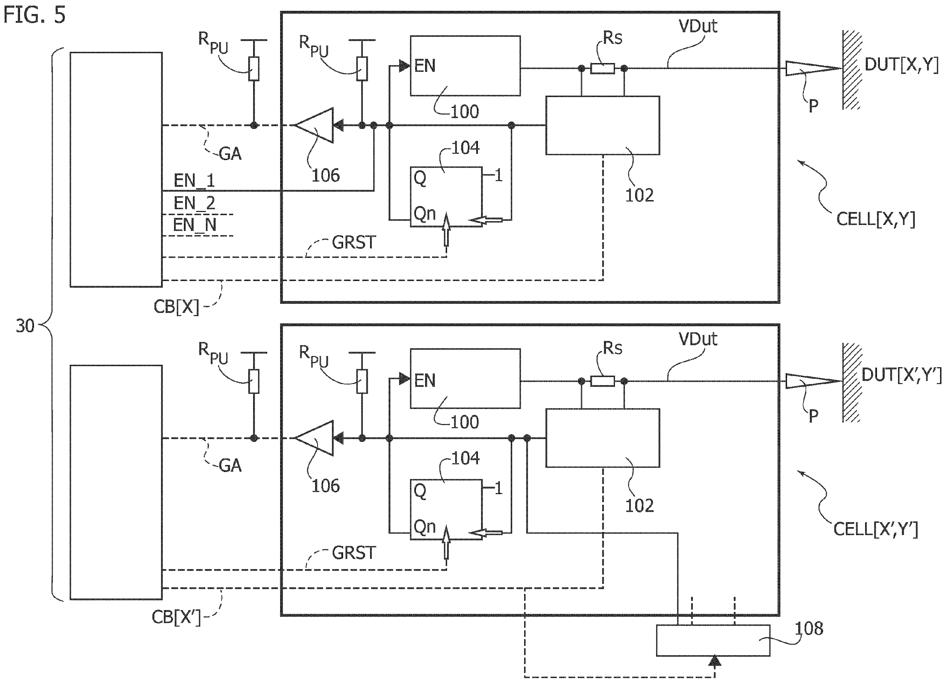

Figure 5 is a representation of a part of a system as discussed herein that is deliberately simplified for ease of explanation.

Figure 5 shows two clusters, each of them with just one cell, namely a first cluster (CLUSTER[X]) represented by a cell C[X,Y] and a second cluster (CLUSTER[X']) represented by a cell C[X',Y'], both cells being based on the circuit layout introduced in Figure 4.

Parts or elements like parts or elements already introduced in Figure 4 are thus indicated with like reference signs in Figure 5 and a corresponding detailed description will not be repeated for brevity.

Figure 5 shows that in order to keep a cluster disabled after reset along the lines discussed in the foregoing:
either additional lines EN_1, EN_2, ..., EN_N may be involved, or
a digitally controlled GPIO extender (expander) 108 can be used instead.

For simplicity, both options are represented in Figure 5.

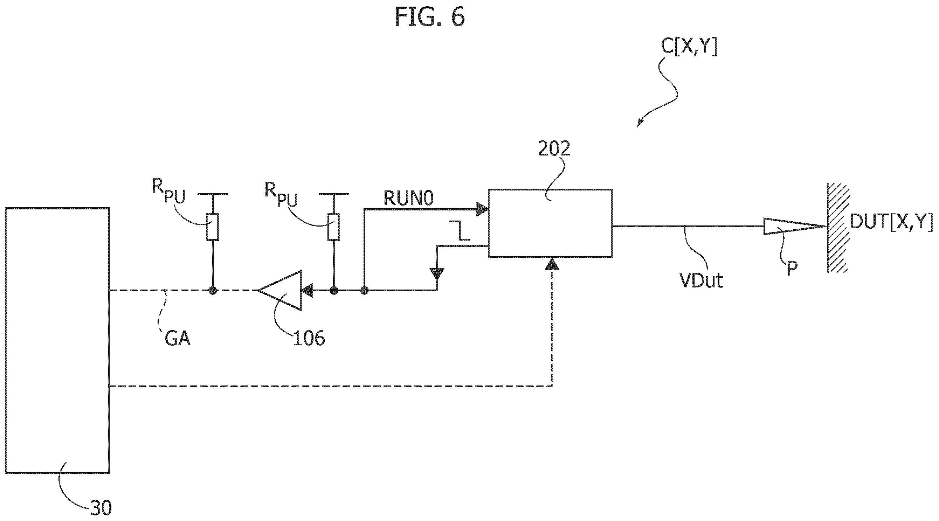

Figure 6 shows, by direct comparison with Figure 4, that operation as discussed previously (namely, in response to fault condition detected in a cell: at least temporarily disabling a cell for protection purposes, generating a signal indicative of such a fault condition detected, providing a telemetry query function for logic 30, and thus the tester 40) can be implemented also via fully digital power management integrated circuitry (digital PMIC) 202 configured to manage directly a signal VDut on a DUT line resulting from probe contact with a corresponding DUT.

Again, parts or elements like parts or elements already introduced in Figures 4 and 5 are indicated with like reference signs in Figure 6 and a corresponding detailed description will not be repeated for brevity.

A digital PMICs is a (complex) fully programmable System-on-Chip (SoC) that facilitates setting voltage and fault currents via a control bus.

Digital PMICs can "natively" measure voltages and currents, implement self-protection measures (shut-down, for instance) and generate alert signals in case of a fault, while also including registers where a flag indicative of a faulty condition can be stored.

By way of simple explanation, a single digital PMIC can be configured to implement the functions of the elements 100, 102 and 104 of Figure 4 with operation controlled by the logic circuitry 30 via a control bus.

The layout exemplified in Figure 6 refers to a fully digital PMIC implementation of these functions, which may however be regarded as unduly expensive, by also noting that PMICs occupy a large semiconductor area.

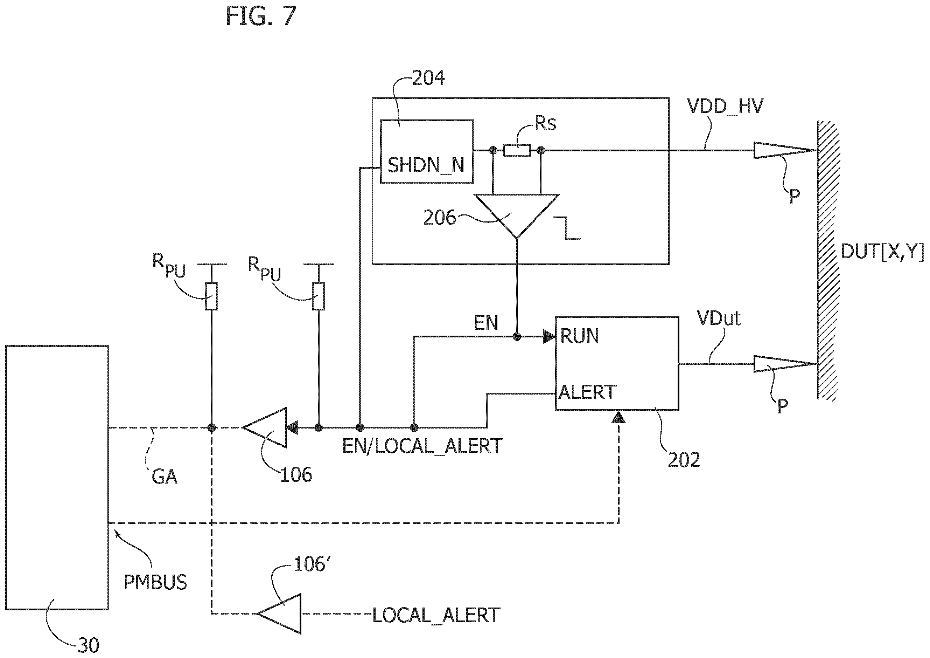

Figure 7 (where, once again, parts or elements like parts or elements already introduced in the foregoing are indicated with like reference signs in without repeating a corresponding detailed description) shows that a PMIC-based implementation of a cell C[X, Y] may include one or more (only one is illustrated for simplicity) high-voltage low-current rail VDD_HV.

A power switch connected to a "global" rail and a low-dropout regulator (LDO regulator: a DC linear voltage regulator circuit that can operate even when the supply voltage is very close to the output voltage) may come into play for that purpose.

Such a solution (essentially a LDO regulator and a meter) represents for low current rails a judicious trade-off leading to a reduction of cost and occupation area in comparison with a fully digital PMIC implementation.

Such a solution involves external sensing (via a latched sense comparator, for instance) in parallel with a local enable line.

Figure 7 shows a LDO regulator 204 and a latched current sense comparator 206 sensing the voltage across an amperometry resistor Rs (the same designation of Figure 4 is used for simplicity, even though the associated circuitry is different) in a current flow line between the LDO regulator 204 and the line (additional rail) VDD_HV.

This may be a low-current, high-voltage rail but in certain implementations a low voltage and operation close to a high-current rail may be envisaged.

The output from the current sense comparator 206 is applied as an enable signal EN to a RUN input of a digital PMIC 202 that, in addition to a voltage VDut (this may be a low-voltage VDD_LV) towards the DUT[X,Y] associated therewith provides, under the control of the control bus CB[X] (this may be coupled to a PMBUS^{™} pin in the logic circuitry) a (local) alert signal LOCAL_ALERT towards the buffer 106.

The latched comparator 206 and the buffer 106 can be managed with dedicated signals from the logic 30 or by local controlling signals managed via the control bus and a GPIO extender (so that the interface outside the cell is consistent).

Figure 7 shows that local alerts labelled LOCAL_ALERT and LOCAL_ALERT' from two different cells (within a same cluster) may serve to produce a combined alert: a global alert GA for all the clusters may be considered as an example.

In that way, a global alert signal GA can be produced by combining (as a wired OR, for instance) the signal LOCAL_ALERT with one or more homologous alert signals such as the signal LOCAL_ALERT' from buffers 106' in other cells (only one is represented here in dashed lines for simplicity).

As illustrated in Figure 7, the signal LOCAL_ALERT is also applied to a SHDN_N pin of the LDO regulator 204 to put the negative side thereof into a low power shutdown state thus disabling the cell power supply circuitry (the LDO regulator 204) in the individual cell found to be "faulty" as discussed previously in connection with Figure 4.

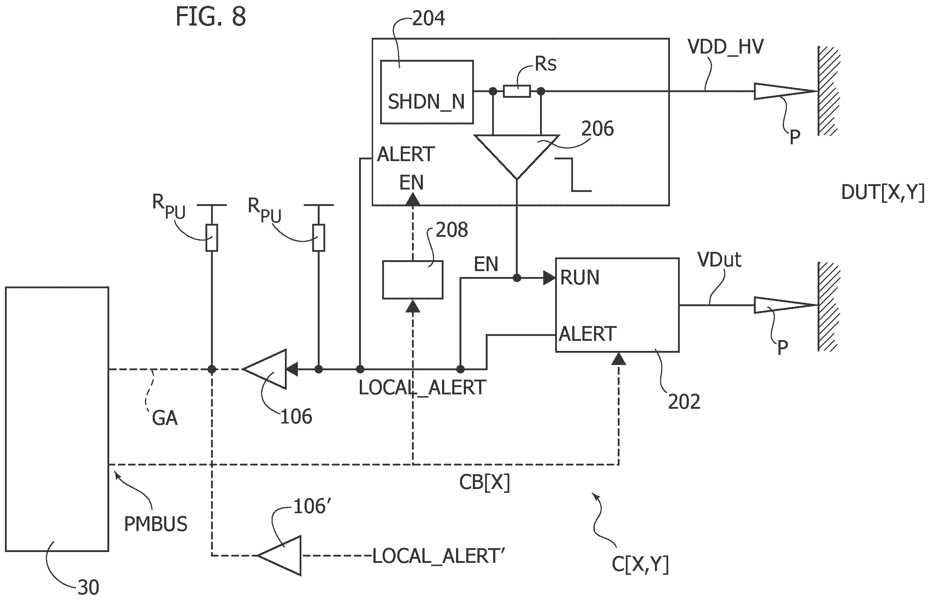

Figure 8 shows that general purpose input/output (GPIO) extender/expander circuitry (hereinafter GPIO extender) 208, controlled by the control bus CB[X], can be included in a circuit layout as exemplified in Figure 7 in order to manage the enable signal EN of the LDO regulator 204 independently of the PMIC 202.

In that way, the logic circuitry 30 may again send (over the bus CB[X]) a restore signal to re-enable (via the EN input of the LDO 204 acting as the cell power supply circuitry) one or more individual cells that have been temporarily disabled for protection purposes so that these cells can be re-enabled in view of a next touch-down action on a "new" device under test.

Again, the logic circuitry 30 can exclude from such a restore action individual cells that include a memory element (here, in the PMIC 202) having stored therein - just like the flip-flop 104 of Figure 4 - a flag indicative of a persistent fault condition detected in the cell repeatedly, that is during subsequent touch-down actions, which is expectedly indicative of a fault (damage) in the cell (shorted pins, for instance).

The system can thus disable these individual cells permanently, that is until these cells are serviced and rendered again fit for use in testing DUTs coupled therewith.

Figures 6 to 8 (just like Figure 4 and 5) are thus exemplary of a system wherein the cells can be programmed in terms of rail power-on sequence within a cell and alert values so that cells (other than any cell being "disqualified") can be turned on to execute testing while telemetry is collected run-time, formatted and forwarded to a tester.

Figures 6 to 8 (just like Figure 4 and 5) are exemplary of a system that optimizes the use of logic resources 30, with the faulty supply rail implementing a safeguard mechanism (immediate shutdown or foldback, for instance) which facilitates equipment protection while faults can be managed (at a cell level) with a supply rail experiencing a fault (an overcurrent, for instance) setting an alert which is common to a whole cluster.

Figures 6 to 8 (just like Figure 4 and 5) are exemplary of solutions where a cell may store a flag (in the flip-flop 104 or in the PMIC 202) indicating the element impacted by a fault condition. An associated logic circuitry 30 can thus query the cells and the related information, in response to an alert flag processed by the control logic. Once an alert is triggered, the logic circuitry 30 can identify the cluster from which the alert originates and perform a query of the elements within the cluster (keeping the test running for the remaining DUTs) to single out the cell related to the fault and the faulty supply rail. That information is relayed to a tester that can decide adequate actions (for instance, a cell can be marked as damaged if the fault is related to the cell electronics with that cell disabled permanently (that is, until the cell is serviced and fixed) with the cell marked by a "broken" alert.

It will be appreciated that referring to individual cells as CELL[0,0], CELL [0,M] ; CELL[1,0], CELL[1,M], ... CELL[N,0], CELL[N,M] is intended to highlight the relationship with respective semiconductor devices under test (referred to as DUT[0,0], DUT[0,M]; DUT[1,0], DUT[1,M], ... DUT[N,0], DUT[N,M]). Referring to individual cells as CELL[0,0], CELL [0,M] ; CELL[1,0], CELL[1,M], **...** CELL[N,0], CELL[N,M] also facilitates appreciating the nature and role of the cell clusters and the alarm signals, which are referred to as CLUSTER[0], CLUSTER[1], ..., CLUSTER[N] and ALERT[0], ALERT[1], ..., ALERT [N]; GA.

Without prejudice to the underlying principles, the details and embodiments may vary, even significantly, with respect to what has been described by way of example only without departing from the extent of protection.

The extent of protection is determined by the annexed claims.

## Claims

1. A system for testing semiconductor devices (W), the system comprising:
a probing array (PS) of individual cells (CELL[0,0], CELL [0,M] ; CELL[1,0], CELL[1,M]; ...; CELL[N,0], CELL[N,M]) configured to apply electrical stimulation signals (SS) to respective semiconductor devices under test (DUT[0,0], DUT[0,M]; DUT[1,0], DUT[1,M]; ...; DUT[N,0], DUT[N,M]) and to detect a fault condition in a respective semiconductor device under test (DUT[0,0], DUT[0,M]; DUT[1,0], DUT[1,M]; ...; DUT[N,0], DUT[N,M]) based on electrical reaction signals (MS) received therefrom in response to said electrical stimulation signals (SS) applied thereto;
wherein:
the individual cells (CELL[0,0], CELL[0,M]; CELL[1,0], CELL[1,M]; ...; CELL[N,0], CELL[N,M]) in the probing array (PS) are configured (104, 202) to be at least temporarily disabled (100; 204) in response to a fault condition detected in the respective semiconductor device under test (DUT[0,0], DUT[0,M]; DUT[1,0], DUT[1,M]; ...; DUT[N,0], DUT[N,M]);
the individual cells (CELL[0,0], CELL[0,M]; CELL[1,0], CELL[1,M]; ...; CELL[N,0], CELL[N,M]) in the probing array (PS) are arranged in cell clusters (CLUSTER[0], CLUSTER[1], ..., CLUSTER[N]), wherein the cell clusters (CLUSTER[0], CLUSTER[1], ..., CLUSTER[N]) are configured to issue alert signals (ALERT[0], ALERT[1], ..., ALERT [N] ; GA) indicative of a fault condition detected (102; 206) in at least one individual cell (CELL[0,0], CELL [0,M] ; CELL[1,0], CELL[1,M]; ...; CELL[N,0], CELL[N,M]) therein; and
the system comprises logic circuitry (30) configured to perform, based on said alert signals (ALERT [0], ALERT[1], ..., ALERT [N]; GA), a query of individual cells (CELL[0,0], CELL[0,M]; CELL[1,0], CELL[1,M]; ...; CELL[N,0], CELL[N,M]) in the probing array (PS) and identify individual cells (CELL[0,0], CELL [0,M] ; CELL[1,0], CELL[1,M]; ...; CELL[N,0], CELL[N,M]) in the probing array (PS) wherein a fault condition is detected.

2. The system of claim 1, comprising combination circuitry (106) configured to combine respective alert signals (ALERT[0], ALERT[1], ..., ALERT [N]) from a plurality of said cell clusters (CLUSTER[0], CLUSTER[1], ..., CLUSTER[N]) to produce therefrom at least one combined alert signal (GA) common to a plurality of said cell clusters (CLUSTER[0], CLUSTER[1], ..., CLUSTER[N]).

3. The system of claim 2, wherein said combination circuitry comprises buffer stages (106) configured to produce said at least one combined alert signal (GA) as a wired-OR combination of a plurality of said respective alert signals (ALERT[0], ALERT[1], ..., ALERT [N]).

4. The system of any of the previous claims, wherein the logic circuitry (30) is configured to perform said query of said individual cells (CELL[0,0], CELL[0,M]; CELL[1,0], CELL[1,M]; ...; CELL[N,0], CELL[N,M]) in the probing array (PS) limited to the individual cells (CELL[0,0], CELL [0,M] ; CELL[1,0], CELL[1,M]; ...; CELL[N,0], CELL[N,M]) in the probing array (PS) included in cell clusters (CLUSTER[0], CLUSTER[1], ..., CLUSTER[N]) having issued an alert signal (ALERT[0], ALERT[1], ..., ALERT[N]).

5. The system of any of the previous claims, wherein said logic circuitry (30) is configured to:
identify in response to said query individual cells (CELL[0,0], CELL [0,M] ; CELL[1,0], CELL[1,M]; ...; CELL[N,0], CELL[N,M]) in the probing array (PS) wherein a persisting fault condition is detected; and
permanently disable individual cells (CELL[0,0], CELL [0,M] ; CELL[1,0], CELL[1,M]; ...; CELL[N,0], CELL[N,M]) in the probing array (PS) wherein said persisting fault condition is detected.

6. The system of any of the previous claims, wherein:
the individual cells (CELL[0,0], CELL[0,M]; CELL[1,0], CELL[1,M]; ...; CELL[N,0], CELL[N,M]) in the probing array (PS) are configured (104, 202) to have stored therein a flag indicative of a fault condition detected in the cell (CELL[0,0], CELL[0,M]; CELL[1,0], CELL[1,M]; ...; CELL[N,0], CELL[N,M]), and
said logic circuitry (30) is configured to perform said query of individual cells (CELL[0,0], CELL[0,M]; CELL[1,0], CELL[1,M]; ...; CELL[N,0], CELL[N,M]) in the probing array (PS) and identify individual cells (CELL[0,0], CELL [0,M] ; CELL[1,0], CELL[1,M]; ...; CELL[N,0], CELL[N,M]) in the probing array (PS) wherein a fault condition is detected based on said flag stored therein (104; 202).

7. The system of any of the previous claims, wherein the individual cells (CELL[0,0], CELL[0,M]; CELL[1,0], CELL[1,M]; ...; CELL[N,0], CELL[N,M]) of the probing array (PS) include cell power supply circuitry (20[0,0], 20[0,M] ; 20[1,0], 20[1,M] ; ...; 20[N,0], 20[N,M]) to selectively apply electrical power to a respective semiconductor device under test (DUT[0,0], DUT[0,M]; DUT[1,0], DUT[1,M]; ...; DUT[N,0], DUT[N,M]) as well as fault detection electronics (10[0,0], 10[0,M]; 10[1,0], 10[1,M] ; ...; 10[N,0], 10[N,M]) configured to apply said electrical stimulation signals (SS) and detect said electrical reaction signals (MS) received in response to said electrical stimulation signals (SS).

8. The system of claim 7, wherein said cell power supply circuitry comprises a supply regulator (100, 204) and said fault detection electronics comprises an amperometry meter (102, 206).

9. The system of claim 7 or claim 8, comprising general purpose input output, GPIO circuitry (208) coupled to said cell power supply circuitry (204) and to digital power management circuitry (202) in the individual cells (CELL[0,0], CELL[0,M]; CELL[1,0], CELL[1,M]; ...; CELL[N,0], CELL[N,M]) of the probing array (PS), the GPIO circuitry (208) configured to at least temporarily disable (EN) said cell power supply circuitry (204) in response to a fault condition detected in the respective semiconductor device under test (DUT[0,0], DUT[ 0,M]; DUT[1,0], DUT[1,M]; ...; DUT[N,0], DUT [N,M]) .

10. A method of testing semiconductor devices (W) via a probing array (PS) including individual cells (CELL[0,0], CELL [0,M] ; CELL[1,0], CELL[1,M]; ...; CELL[N,0], CELL[N,M]) configured to co-operate with respective semiconductor devices under test (DUT[0,0], DUT[0,M]; DUT[1,0], DUT[1,M]; ...; DUT[N,0], DUT[N,M]) wherein the individual cells (CELL[0,0], CELL[0,M]; CELL[1,0], CELL[1,M]; ...; CELL[N,0], CELL[N,M]) in the probing array (PS) are arranged in cell clusters (CLUSTER[0], CLUSTER[1], ..., CLUSTER[N]), wherein the method comprises:
establishing electrical contact (P) of individual cells (CELL[0,0], CELL [0,M] ; CELL[1,0], CELL[1,M]; ...; CELL[N,0], CELL[N,M]) in the probing array (PS) with respective semiconductor devices under test (DUT[0,0], DUT[0,M]; DUT[1,0], DUT[1,M]) and selectively applying via the individual cells (CELL[0,0], CELL[0,M]; CELL[1,0], CELL[1,M]; ...; CELL[N,0], CELL[N,M]) in the probing array (PS) electrical stimulation signals (SS) to the respective semiconductor device under test (DUT[ 0,0], DUT[ 0,M]; DUT[1,0], DUT[1,M]; ...; DUT[N,0], DUT[N,M]) wherein a fault condition in a respective semiconductor device under test (DUT[0,0], DUT[0,M]; DUT[1,0], DUT[1,M]; ...; DUT[N,0], DUT[N,M]) is detected based on electrical reaction signals (MS) received therefrom in response to said electrical stimulation signals (SS) applied thereto;
at least temporarily disabling (100; 204) the individual cells (CELL[0,0], CELL[0,M]; CELL[1,0], CELL[1,M]; ...; CELL[N,0], CELL[N,M]) in the probing array (PS) in response to a fault condition detected in the respective semiconductor device under test (DUT[0,0], DUT[0,M]; DUT[1,0], DUT[1,M]; ...; DUT[N,0], DUT[N,M]);
issuing from said clusters (CLUSTER[0], CLUSTER[1], ..., CLUSTER[N]) of individual cells (CELL[0,0], CELL [0,M] ; CELL[1,0], CELL[1,M]; ...; CELL[N,0], CELL[N,M]) in the probing array (PS) respective alert signals (ALERT[0], ALERT[1], ..., ALERT [N] ; GA) indicative of a fault condition detected (102; 206) in at least one individual cell (CELL[0,0], CELL[0,M]; CELL[1,0], CELL[1,M]; ...; CELL[N,0], CELL[N,M]) therein; and
performing, based on said alert signals (ALERT[0], ALERT[1], ..., ALERT [N]; GA), a query of individual cells (CELL[0,0], CELL [0,M] ; CELL[1,0], CELL[1,M]; ...; CELL[N,0], CELL[N,M]) in the probing array (PS) and identifying individual cells (CELL[0,0], CELL[0,M]; CELL[1,0], CELL[1,M]; ...; CELL[N,0], CELL[N,M]) in the probing array (PS) wherein a fault condition is detected in the respective semiconductor device under test (DUT[ 0,0], DUT[0,M]; DUT[1,0], DUT[1,M]; ...; DUT[N,0], DUT[N,M]).
